# EUROPEAN PATENT SPECIFICATION

(11) **EP 2 103 092 B1**
(45) Date of publication and mention of the grant of the patent: **29.07.2015**
(21) Application number: 07746650.6
(22) Date of filing: 23.05.2007
(51) Int. Cl.: H04M 1/23, G06F 3/023

(54) **CONTROL APPARATUS FOR COMPLEX INPUT INTERFACE**
STEUERVORRICHTUNG UND SCHNITTSTELLE FÜR KOMPLEXE EINGABEN
APPAREIL DE COMMANDE POUR INTERFACE D'ENTRÉE COMPLEXE

(30) Priority: 28.12.2006 KR 20060136202
(43) Date of publication of application: 23.09.2009
(73) Proprietor: Melfas Inc., Seoul 153-801 (KR)
(72) Inventor: RHIM, Byung Sang, Seoul 138-916 (KR); MIN, Dong-Jin, Seoul 151-772 (KR)
(74) Representative: Hatzmann, Martin
(86) International application number: PCT/KR2007/002502
(87) International publication number: WO 2008/082035

(56) References cited:
- EP-A1- 1 265 423
- EP-A2- 1 197 835
- WO-A1-98/19434
- JP-A- 2005 043 983
- US-A- 4 405 918
- US-A- 5 646 649
- US-A1- 2004 077 373
- US-B1- 6 246 862

## Description

### Technical Field

The present invention relates to a user input apparatus provided for integrated processing of user inputs via various types of switches. More particularly, the invention relates to a user input apparatus where each port is usable as an interface for an electrical switch and a mechanical switch.

### Background Art

Today, various functions tend to be integrated in a single digital device due to development of information and communication technology. Accordingly, digital devices having various multimedia functions are released, and a new type of user interface is required.

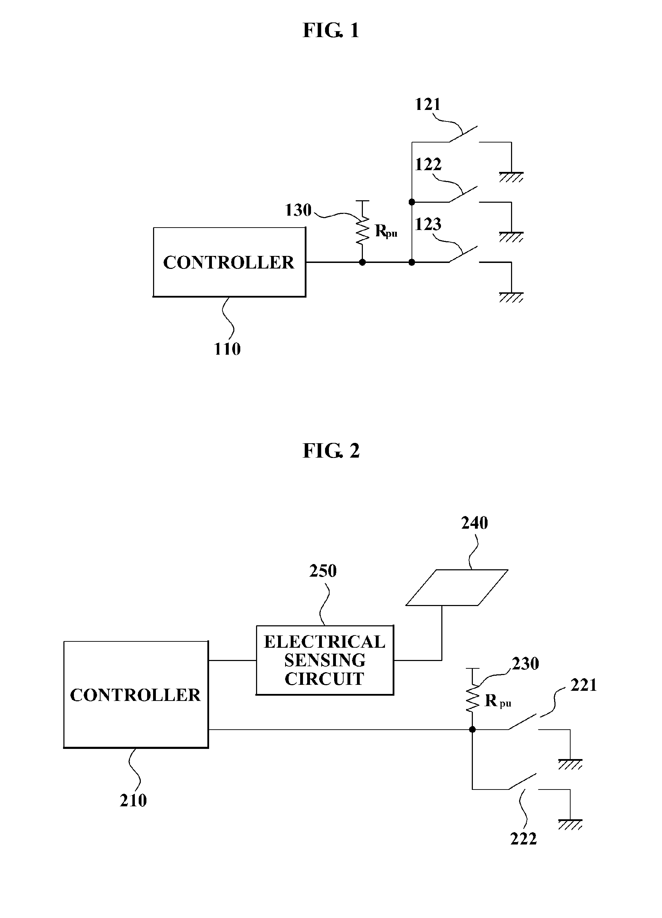

FIG. 1 is a circuit diagram illustrating a configuration of a conventional user input apparatus which receives a user input signal via a mechanical switch. The user input apparatus of FIG. 1 includes one or more mechanical switches 121, 122 and 123, a port of which is connected to ground, and the other port is connected to an interrupt port or input/output port of a controller 110.

Also, a pull-up resistor 130 is connected to a port of the mechanical switches 121, 122 and 123, each of which is connected to the controller 110. Therefore, when any one of the mechanical switches 121, 122 and 123 is closed by a user's input, a voltage level of a path being connected to the controller 110 falls from 'high' to 'low'. The controller 110 detects the user's input using the above-mentioned signal change.

The user input apparatus using the mechanical switches 121, 122 and 123 illustrated in FIG. 1 has advantages in that the user input apparatus may be embodied via a simple circuit configuration, and that it gives a tactile or audio feedback when a button is clicked. Further to this, the user input apparatus of FIG. 1 has an advantage in that power consumption is not great since a leakage current does not exist in a standby mode in which a user's input is not applied.

Recently, however, electrical switches are expanding usages in a user input apparatus, along with said mechanical switches. The electrical switches perform switching operation based on a change in electrical characteristics caused by human touch. Particularly, when continuous inputs are required such as in a navigating mode or a scroll mode, electrical switches are usually more effective than mechanical switches.

As described above, mechanical switches and electrical switches respectively have their own advantages. Accordingly, digital devices adopting electrical switches are normally configured by incorporating mechanical switches in combination with the electrical switches.

FIG. 2 is a circuit diagram illustrating a configuration of a conventional user input apparatus which includes both an electrical switch and a mechanical switch.

Referring to FIG. 2, the electrical switch 240 is operated by an electrical sensing circuit 250 that detects changes in electrical characteristics caused by a user's touch, and the mechanical switches 221 and 222 are connected to a controller 210 in a similar way to that of the conventional user input apparatus of FIG. 1. In this configuration, a pull-up resistor 230 is connected to the mechanical switches 221, 222 and 223 on the ports that are connected to the controller 210, and thus the voltage level of a user input signal inputted to the controller 210 remains 'high' when the mechanical switches 221, 222 and 223 are waiting for a user input, whereas it falls down to 'low' when any one of the mechanical switches 221, 222 and 223 is closed by the user input.

According to the circuit diagram of FIG. 2, the controller 210 controlling a digital device based on the user input received from the electrical switch 240 and the mechanical switches 221 and 222 is required to be provided with control pins or input/output ports to separately control different types of switches. Such increase in the number of control pins is undesirable for the controller 210 since the controller 210 is required to control various types of peripheral devices including the user input apparatus using limited input/output resources.

Also, according to the conventional art, the controller 210 is connected to the mechanical switches 221, 222 and 223 and the electrical switch 240 via a cable that includes plural signal lines in a configuration that the controller 210 and the user input apparatus are respectively mounted on separate bodies of the digital device. However, such a cable including plural signal lines limits freedom of a structural configuration of the digital device due to increased size of the cable. This may cause disadvantages in design and embodiment of the digital device in view of the current miniaturization trend of digital devices.

In brief, a user input apparatus including various types of switches being configured according to the conventional art has increased hardware complexity and control method, and thus yields higher manufacturing costs and harder embodiments. Accordingly, there is an increasing need for an integrated input controller capable of simultaneously handling user inputs via electrical switches and mechanical switches, in case of complex user input apparatus including electrical and mechanical switches.

For solving the above-described problem of the conventional art, a new technique associated with a user input apparatus capable of controlling mechanical and electrical switches in an integrated manner is provided as follows.

US patent application US 2004/0077373 discloses a keypad assembly for a portable telephone, as well as a method for controlling such an assembly.

US Patent no. US 4,405,918 discloses a current sensing circuit for capacitive keyboard arrays.

### Disclosure of Invention

### Technical Goals

The present invention provides an apparatus which controls in an integrated manner a complex input interface that includes an electrical switch and a mechanical switch.

The present invention also provides an integrated solution for controlling a complex input interface by integrating an electrical input unit and a mechanical input unit into a single chip, where the electrical input unit detects a user's touch via an electrical switch, and the mechanical input unit detects whether or not a mechanical switch is closed.

The present invention also provides a user input apparatus which can effectively reduce power consumption that may be caused by a constant operation of an electrical switch by employing, as an activation signal of the electrical switch, an interrupt signal generated in response to a user's input sensed from any one of mechanical switches.

### Technical solutions

According to an aspect of the present invention, there is provided a user input apparatus according to claim 1.

### Brief Description of Drawings

FIG. 1 a circuit diagram illustrating a configuration of a conventional user input apparatus which receives a user input signal via a mechanical switch;
FIG. 2 is a circuit diagram illustrating a configuration of a conventional user input apparatus which includes both an electrical switch and a mechanical switch;
FIG. 3 is a circuit diagram illustrating an internal configuration of a user input apparatus according to an embodiment of the present invention;
FIG. 4 is a circuit diagram illustrating an internal configuration of a user input apparatus according to another embodiment of the present invention;
FIG. 5 is a circuit diagram illustrating an internal configuration of a user input apparatus according to still another embodiment of the present invention; and
FIG. 6 illustrates an exterior of a portable terminal device having a user input apparatus of the present invention and connection of the user input apparatus and a controller mounted on the device.

### Best Mode for Carrying Out the Invention

Hereinafter, a configuration of a user input apparatus according to the present invention will be described in detail by referring to the accompanied drawings.

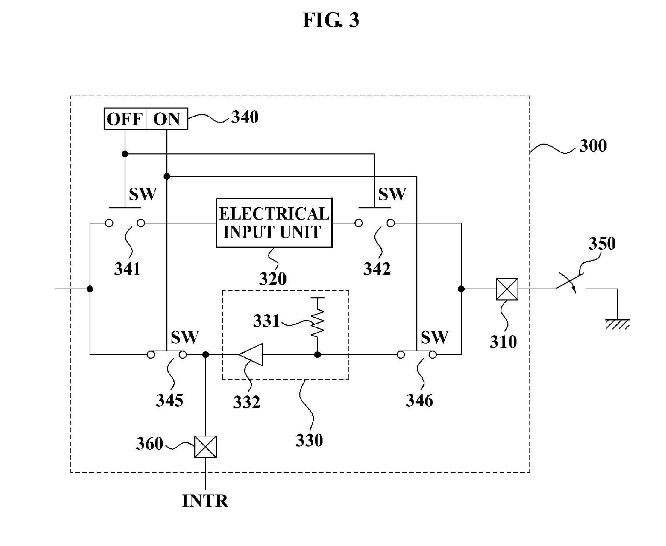

FIG. 3 is a circuit diagram illustrating an inner configuration of a user input apparatus 300 according to an embodiment of the present invention.

Referring to FIG. 3, the user input apparatus 300 includes an input port 310. The input port 310 transmits a user input signal inputted from outside to an electrical input unit 320 and a mechanical input unit 330 being located in the user input apparatus 300. The input port 310 may be connected to an electrical switch or a mechanical switch that is located outside the user input apparatus 300. It is illustrated in FIG. 3 that the input port 310 is connected to a mechanical switch 350.

Specifically, when the user input apparatus 300 is implemented as an integrated circuit (IC), the input port 310 may have a metal lead being connected to a wire outside the IC, a bonding pad being located inside the IC, and a bonding wire connecting the bonding pad with the metal lead. While it is illustrated in FIG. 3 that the input port 310 is connected to a single mechanical switch via a single lead pin, the input port 310 of the user input apparatus 300 according to the present invention may include at least one additional lead that is connected to another line for control signal transfer, etc.

Further, only a single input port is shown in FIG. 3 for convenient description. However, the user input apparatus 300 according to the present invention may include a plurality of input ports 310. Accordingly, FIG. 3 may be understood as a circuit being connected to any one of the plurality of input ports 310. An additional circuit configuration for the plural input ports 310 will later be described in detail.

Each of the user input signal received via the input port 310 may be transmitted to the electrical input unit 320 and the mechanical input unit 330. The electrical input unit 320 receives a user input signal inputted via the electrical switch when there is an electrical switch connected to the input port. Hereinafter, the user input signal inputted via the electrical switch is referred to as "electrical input signal."

For reference, the terminology "electrical switch", which is used throughout the claims and the specification of the present invention, may indicate a touch sensing switch that includes a touch electrode. The touch sensing switch is configured to detect changes in electrical characteristics such as capacitance, inductance and resistance being generated when a human body contacts the touch electrode in a direct manner, or in an indirect manner via a conductor or an non-conductor by including the touch electrode. Further to this, the "electrical switch" may be widely interpreted as including a proximity sensing switch that detects proximity of a user in various ways. For example, the proximity sensing switch detects proximity of a human body by sensing changes of an electromagnetic field or illumination changes, or by measuring a time when an ultrasonic or electromagnetic wave returns after being reflected by the human body.

According to an embodiment of the present invention, the electrical input unit 320 may include a control signal generation unit which generates a control signal for operating the electrical switch and an input signal receiving unit for receiving an electrical input signal. Normally, this type of configuration corresponds to a case in which the electrical switch is driven by an additional control signal, for remaining in a standby mode or sensing a user input from the electrical switch. However, different from the above embodiment, the electrical input unit 320 may not include a functional block for generating a control signal in a case that the electrical switch does not need a driving signal, or when the electrical switch is simultaneously operated by an additional controller that exists outside the user input apparatus 300.

Meanwhile, the mechanical input unit 330 receives a user input signal that is inputted via a mechanical switch 350 when the mechanical switch 350 is connected to the input port 310. Hereinafter, the user input signal being inputted via a mechanical switch is referred to as a "mechanical input signal". Here, the "mechanical switch" may indicate a switch whose open/close state is determined by user's pressure applied continuously or momentarily. A dome switch such as a rubber dome and a metal dome, which is widely used in various types of digital devices, is a good example of the mechanical switch 350.

As illustrated in FIG. 3, the mechanical input unit 330 may include a pull-up resistor 331 that is connected to a path to the input port 310. Thus, according to the circuit diagram of FIG. 3, a voltage level of a mechanical input signal is 'high' due to the pull-up resistor 331 when the mechanical switch 350 is open and remains in a standby mode, waiting for a user's input. However, when a user applies pressure and the mechanical switch 350 is closed, the voltage level of the mechanical input signal falls to 'low'.

When the mechanical switch 350 is connected to a power terminal having a positive voltage instead of being connected to ground, and when the pull-up resistor 331 is replaced with a pull-down resistor, a voltage level of the mechanical input signal rises to 'high' because the mechanical switch 350 is closed.

The mechanical input unit 330 detects changes of the mechanical input signal, or transmits it to an external controller. The external controller is designed to control various types of peripheral devices mounted on a digital device, including the user input apparatus 300. The external controller may be configured in the form of a central processing unit (CPU), a digital signal processor (DSP), or an application specific integrated chip (ASIC). A buffer 332 transmits the mechanical input signal to an outside. The buffer 332 may be included in the mechanical input unit 330 as illustrated in FIG. 3, or may be included in an additional input/output circuit in an integrated manner.

As described above, in addition to the mechanical switch 350, an electrical switch may also be connected to the input port 310. However, the electrical input port 320 is not used in FIG. 3 since the mechanical switch 350 is connected to the input port 310. In this manner, one of the electrical input unit 320 and the mechanical input unit 330 is selected for operation, while the other is deactivated, based on the type of switch being connected to the input port 310. A switch selection unit 340 stores the selection information for selecting which input unit to activate or deactivate.

The switch selection unit 340 may include switches 341, 342, 345 and 346 that are respectively connected to signal input/output ports of the electrical input unit 320 and the mechanical input unit 330. Also, the switch selection unit 340 includes a register that stores the selection information for the electrical input unit 320 and the mechanical input unit 330 as a flag type. As illustrated in FIG. 3, the register stores flag values of 'ON/OFF', which instruct whether to activate each of the electrical input unit 320 and the mechanical input unit 330, and thus the register's output signals fed to the switches 341, 342, 345 and 346 determine whether to open/close the switches 341, 342, 345 and 346.

Each flag value of the switch selection unit 340 can be inputted via an external controller to the user input apparatus 300. Types of switches being connected to a specific input port 310 of the user input apparatus 300 are not generally changed after they are determined and their hardware configuration is fixed at the time of digital device design. Accordingly, the controller may set up the switch selection unit 340's flag values corresponding to the respective input ports 310 at once when initializing the user input apparatus 300.

As an example, in FIG. 3, a flag value corresponding to the mechanical input unit 330 is configured 'ON', and a flag value corresponding to the electrical input unit 320 is configured 'OFF', so that the user input apparatus 300 is used to receive a mechanical input signal. Accordingly, a user input signal being received via the input port 310 is transmitted only to the mechanical input unit 330 via a closed switch 346, and only an output signal of the mechanical input unit 330, among output signals of the electrical and mechanical switches 320 and 330, is outputted via a closed switch 345.

The outputted user input signal may be inputted to an external controller to be used in controlling the digital device. However, in another embodiment, the user input apparatus 300 may include a device controller inside that functions to generate a control signal for controlling the digital device based on the user input signal.

When two flag values are configured 'OFF', both the electrical input unit 320 and the mechanical input unit 330 are deactivated, so that user input signals are not received via the corresponding input port 310 regardless of types of the switches being connected to an outside. While the flag values may be configured 'OFF' when no switch is connected to the input port 310, they may be configured as such also when the electrical switch is connected and is required to be temporarily deactivated to prevent ongoing power consumption.

Referring back to FIG. 3, the mechanical input signal being received via the mechanical input unit 330 may be outputted to an outside of the user input apparatus 300 via an interrupt port 360. When the mechanical switch 350 is closed, the output signal may operate as a low-level interrupt where a voltage level of the mechanical input signal falls from 'high' to 'low', and the output signal may operate as a high-level interrupt where a voltage level of the mechanical input signal rises from 'low' to 'high'. In this manner, the interrupt signal being outputted to the outside of the user input apparatus 300 may be inputted to an external controller so that it can be used as, e.g., a wake-up signal for waking up peripheral devices being connected to the controller from a sleep mode.

As an example, the mechanical input signal being generated when a user presses a button and accordingly the mechanical switch 350 is closed may be inputted to the controller as the interrupt signal so that a display unit of the digital device is activated. In another example, the interrupt signal may be received on the controller side when the mechanical switch 350 is closed at the time of a slide-type cellular phone's slide unit is moved. Then the controller switches a flag value of the switch selection unit 340 from 'OFF' to 'ON' with respect to an electrical input unit of another input port where an electrical switch is connected.

According to an embodiment of the present invention, the wake-up function of the electrical input unit 320 using a closed mechanical switch 350 may be implemented via signal transmission inside the input apparatus 300 without assistance of the controller. This implies that a self wake-up function can be implemented by employing inside the user input apparatus 300 a logic means for activating an electrical input unit of an input port which is connected to an electrical switch based on the output signal of the mechanical input unit 330.

Different from the mechanical switch 350, the electrical switch continuously consumes power since a predetermined level of current needs to flow on a circuit to detect a user's touch input. Accordingly, it is undesirable for a portable terminal device having a limited power supply from a battery or such that the electrical switch is always on standby while waiting for a user's touch to wake-up the digital device. This means that a wake-up of a digital device or an electrical sensor may be implemented using the mechanical switch 350 that has no current flow in a standby mode. For this, in the present invention, a mechanical input signal is either outputted as an interrupt signal or used to activate the electrical input unit 320 inside the user input apparatus 300.

According to an embodiment of the present invention, the electrical input unit 320 and the mechanical input unit 330 may be integrated in a single chip. Through such an implementation, a plurality of discrete devices can be replaced with a single chip and the user input apparatus' size can thus be reduced. The reduced size may contribute to miniaturization of a digital device, increased freedom of circuit layout, and to integration of printed circuit boards (PCB) Therefore, embodiment of the digital device becomes facilitated.

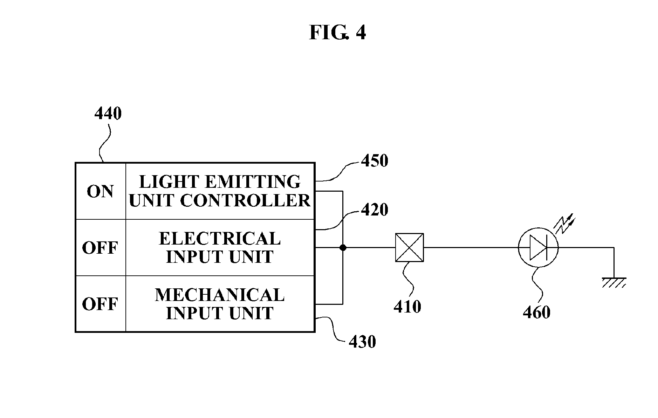

FIG. 4 is a circuit diagram illustrating an inner configuration of a user input apparatus according to another embodiment of the present invention. The circuit diagram of FIG. 3 is simplified in FIG. 4 by omitting switches 341, 342, 345 and 346 that are connected to the switch selection unit 340 and depicting a switch selection unit 440 by using a register including bits which are configured either 'ON' or 'OFF'. Referring to FIG. 4, a light emitting unit 460 is connected to an input port 410, and a switch selection unit 440 sets a flag value associated with a light emitting unit controller 450 to 'ON' and another flag values associated with the remaining units to 'OFF'.

As illustrated in FIG. 4, the user input apparatus according to this embodiment further includes a light emitting unit controller 450, in addition to an electrical input unit 420 and a mechanical input unit 430. The light emitting unit controller 450 is connected to the input port 410 in parallel, in the same manner as the electrical input unit 420 and the mechanical input unit 430.

The light emitting unit controller 450 generates and transmits a light emitting control signal that controls light emitting of a light emitting unit 460 connected to the input port 410. The light emitting control signal is generated in response to a user input which is received via the corresponding electrical or mechanical switch. As an example, when a mechanical switch connected to another input port is closed, the light emitting control signal may turn on the light emitting unit 460. As another example, when a user input is detected at a touch electrode of an electrical switch adjacent to the light emitting unit 460 and the electrical input signal is received from the electrical switch, the light emitting unit 460 may be turned on for a predetermined time. In the above embodiment, the term "adjacent to" indicates a nearest location to a specific light emitting unit among plural light emitting units 460 being arranged in parallel with a plurality of electrical switches, or indicates a location that can be determined by a user as corresponding to the specific light emitting unit. As described above, since the light emitting control signal is generated in response to the received user input signal, feedback information about the user's input can be provided.

For reference, the light emitting unit 460 may include various light emitting devices, such as light emitting diodes, whose on/off state, colors or brightness is determined by an electrical signal.

According to another embodiment of the present invention, the user input apparatus may include a sound unit controller, which is connected thereto in a similar way as that of the light emitting unit controller 450. When a user input is received from an electrical switch or a mechanical switch being associated with a sound unit connected to the input port, the sound unit controller transmits a sound control signal to the sound unit to thereby provide an auditory feedback for the user input.

As an example, when an electrical input signal, which is generated in response to a user's touch, is received from a specific electrical switch, the sound unit controller may transmit a sound unit control signal that controls the sound unit to generate a predetermined sound such as a 'beep' sound. In this instance, when input ports receiving the electrical input signals are different from each other, different sounds may be generated. As an example of the above described case, a user input apparatus in a mobile terminal is constituted in a keypad form, including a plurality of electrical switches.

According to the above-mentioned two embodiments, the light emitting unit controller 450 or the sound unit controller may be integrated into a single chip with the electrical input unit 420 and the mechanical input unit 430. In this manner, the user input apparatus' size can be reduced by integrating core elements of the user input apparatus in a single chip and thus substituting multiple elements with the single chip.

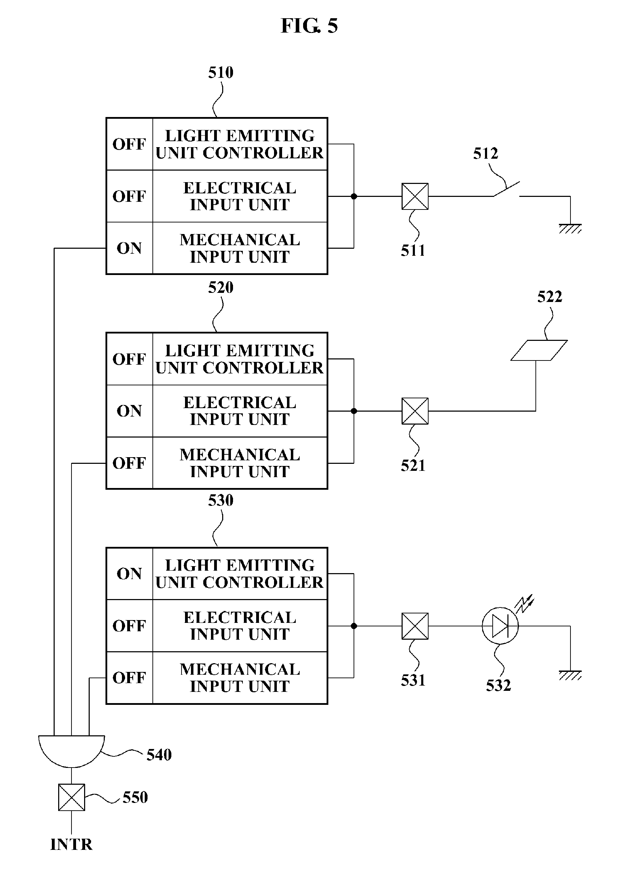

FIG. 5 is a circuit diagram illustrating an inner configuration of a user input apparatus according to still another embodiment of the present invention.

According to FIG. 5, the user input apparatus includes a plurality of input ports 511, 521 and 531, and user input processing blocks 510, 520 and 530 which are respectively connected to the corresponding input ports 511, 521 and 531. Each of the user input processing blocks 510, 520 and 530 includes an electrical input unit, a mechanical input unit and a light emitting unit controller, as well as a switch selection unit for storing, in a flag form, selection information associated with any one of said three elements. In this instance, the light emitting unit controller may or may not be included depending on the form of embodiment.

In the embodiment of FIG. 5, each of the input ports 511, 521 and 531 is respectively connected to a different device. The input port 511 is connected to a mechanical switch 512, while the input port 521 is connected to an electrical switch 522 and the input port 531 is connected to a light emitting unit 532.

Accordingly, a switch selection unit corresponding to the input port 511 sets a flag value to 'ON' only for a mechanical input port, whereas a switch selection unit corresponding to the input port 521 sets a flag value to 'ON' only for an electrical input unit, and a switch selection unit corresponding to the input port 531 sets a flag value to 'ON' only for a light emitting unit controller.

As illustrated in FIG. 5, each of the plurality of input ports 511, 521 and 531 included in the user input apparatus can be used either for controlling light emitting unit according to a flag value set up by the switch selection unit, or for receiving an electrical input signal or a mechanical input signal.

In this embodiment, mechanical input unit of each user input processing block 510, 520 or 530 is connected to an interrupt generation unit as in FIG. 5, the interrupt generation unit consisting of a logical AND gate 540. That is, when any one of the plurality of mechanical switches 512 is closed and accordingly a voltage level of a corresponding mechanical input signal falls from 'high' to 'low', an output signal of the AND gate 540 falls from 'high' to 'low'.

The mechanical switch 512 is only connected to a single input port 511 in FIG. 5. However, a plurality of mechanical switches may be connected to a plurality of input ports in an actual embodiment of the present invention. In this instance, an input signal path of a mechanical input unit corresponding to each input port is connected to the AND gate 540 as an input signal to thus output a low-level interrupt signal.

Meanwhile, a low-level interrupt signal output circuit can be configured that operates in the same way as that of the above embodiment by including an inverter in the mechanical input port instead of the buffer 332 of FIG. 3, and using a NOR gate instead of the AND gate 540 of FIG. 5.

In another embodiment, by employing a pull-down resistor instead of the pull-up resistor in FIG. 3 and by connecting mechanical switches 512 not to ground, but to a power voltage terminal having a positive value, and by including an OR gate instead of the NAND gate 540 in order to configure the interrupt generation unit, a high-level interrupt may be implemented where the voltage level rises from 'low' to 'high' at the moment of at least one mechanical switch's closure.

As described with reference to FIG. 3, the interrupt signal may be inputted to a controller that controls various peripheral devices of the digital device including the user input apparatus. When the interrupt signal is generated in accordance with a user's operation of the mechanical switch 512, the controller may activate the electrical switch 522 or the light emitting unit 532 which is connected to the user input apparatus. That is, in case the mechanical switch 512 becomes closed when a user presses a button or moves a slide of a mobile phone, the light emitting unit 532 can be turned on, or the electrical switch 522 which has been in a deactivated mode becomes activated, thereby being able to detect a user's touch. Such a transition to the active mode at the generation of the interrupt signal may be implemented by supplying the electrical input unit or the light emitting unit controller with a power signal.

Different from the above-mentioned configuration, the interrupt signal generated by closure of the mechanical switch 512 may be processed inside the user input apparatus without assistance of an external controller. Specifically, the interrupt signal may be used as a control signal of a switch that connects the electrical input unit or the light emitting unit controller to a power. Accordingly, continuous power consumption of the electrical switch 522 may be prevented, and a more suitable solution for miniaturized digital devices having a limited power supply is provided.

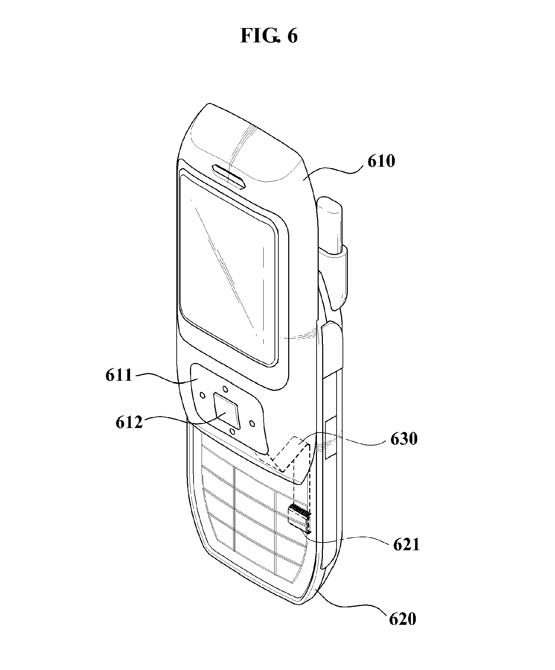

FIG. 6 is a diagram illustrating an exterior of a portable terminal device having a user input apparatus and connection between the user input apparatus and a controller.

The portable terminal device of FIG. 6 includes a first body 610 mounting thereon an electrical switch 611, a mechanical switch 612 and a user input apparatus that receives a user input signal from the switches 611 and 612, and a second body 620 having a controller 621 that controls the user input apparatus and other peripheral devices based on the received user input signal.

Since the user input apparatus of the first body 610 and the controller 621 of the second body 620 are mounted in different PCB circuits, the user input apparatus of the first body 610 and the controller 621 of the second body 620 are connected to each other via a predetermined cable 630. The controller 621 transmits a signal to operate and to control the user input apparatus via the cable 630, and the user input apparatus transmits the user input signal received from the electrical switch 611 and the mechanical switch 612 to the controller 621 via the cable 630.

According to the present invention, a number of signal paths between the user input apparatus and the controller 621 may be greatly reduced since the electrical switch 611 and the mechanical switch 612 are handled in an integrated manner using a single apparatus. That is, in contrast to a keypad-type mechanical switch mounted on the second body 620, along with the controller 621, the mechanical switch 612 mounted on the first body 610 hinders easy implementation of the portable terminal device's structural configuration. This is because, if the controller 621 of the second body 620 is configured to check whether the mechanical switch 612 is closed by using a key scan logic, there have to be added signal paths to the cable 630 as much as the number of the mechanical switches 612, thereby increasing the size of the cable 630. Furthermore, increased size of the cable 630 may cause the portable terminal device's breakdown especially when the first body 610 and the second body 620 are frequently moved with respect to each other, e.g., in a sliding or rotational manner.

Therefore, the portable terminal device may be simply configured by having the user input apparatus mounted on the first body's PCB directly control the mechanical switch 612 mounted on the first body's PCB, and including interrupt paths and a few data paths in the cable 630.

For reference, the term "portable terminal device" used in this specification is a small-sized digital device having portability, and may include mobile communication devices, such as a Personal Digital Cellular (PDC) phone, a Personal Communication Service (PCS) phone, a Personal Handyphone System (PHS) phone, a Code Division Multiple Access (CDMA)-2000 (1X, 3X) phone, a Wideband CDMA phone, a dual band/dual mode phone, a Global Standard for Mobile (GSM) phone, a Mobile Broadband System (MBS) phone, a Digital Multimedia Broadcasting (DMB) terminal, a smart phone, an Orthogonal Frequency Division Multiplexing (OFDM) terminal and an Orthogonal Frequency Division Multiple Access (OFDMA) terminal.

Also, the "portable terminal device" used in the specification of the present invention may include all types of general or specialized computing apparatuses which can perform a certain calculation operation by mounting a microprocessor which can play multimedia, such as a Personal Digital Assistant (PDA), a hand-held PC, a notebook PC, a laptop computer, an MP3 player, and an MD player.

Another aspect of the present invention is associated with an apparatus that detects a touch signal received from a user. The touch signal detecting apparatus according to the present invention may include a touch sensor being connected to at least one electrical switch to detect a touch signal via an electrical switch, a mechanical input sensor being connected to one or more mechanical switches to detect user input via the mechanical switches, and a controller activating the touch sensor when the user input is detected from the at least one of said one or more mechanical switches.

The electrical switch connected to the touch sensor may include a circuit for detecting changes in a capacitance, an inductance or a resistance according to a user's touch.

The mechanical input sensor may include an interrupt generation circuit that generates and outputs an interrupt signal when at least one of the mechanical switches becomes closed due to user's operation of a button or such. Specifically, when the interrupt signal is a low-level interrupt, where a voltage level falls from 'high' to 'low' at the time of mechanical switch's closure, the interrupt generation circuit may be configured as a circuit that feeds signals received from the mechanical switches to input terminals of AND gates and uses output signals thereof as the interrupt signal.

The interrupt signal may be inputted to the controller which is connected to an outside of the touch signal detecting apparatus to control the touch signal detecting apparatus or other peripheral devices, and may be used as a signal activating the peripheral devices that have been in a deactivated mode according to the generation of the interrupt signal. Also, the interrupt signal may activate the touch sensor of the touch signal detecting apparatus to so that it can be turned into a touch-detecting state.

According to an embodiment of the present invention, such activating operations may be performed by connecting a power having been isolated with respect to the touch sensor when the interrupt signal is generated. For this, the interrupt signal may be used as a control signal of a switch that connects the touch sensor and a power.

Hereto, descriptions regarding configurations of the touch signal detecting apparatus according to the present invention have been briefly described. The detailed descriptions of the embodiments from FIGS. 3 through 6 may be applied to descriptions regarding this touch signal detecting apparatus. Specifically, the touch sensor of the touch signal detecting apparatus corresponds to the electrical input unit 320 of FIG. 3, and the mechanical input sensor corresponds to the mechanical input unit 330 of FIG. 3. Therefore, further detailed descriptions regarding the touch signal detecting apparatus will be omitted.

According to the user input apparatus of the present invention, it is possible to control a complex input interface including an electrical switch and a mechanical switch, in an integrated manner.

Specifically, according to the present invention, it is possible to provide a total solution which controls a complex input interface by integrating an electrical input unit and a mechanical input unit into a single chip, the electrical input unit sensing a user's touch via an electrical switch, and the mechanical input unit sensing a user's input via a mechanical switch.

Thus, according to the present invention, it is possible to easily embody a user input apparatus and to reduce manufacturing costs by reducing complexity of the user input apparatus which includes a complex input interface. Also, it is possible to increase a lifetime of the user input apparatus and to reduce repair costs by preventing frequent breakdowns of the user input apparatus which occur due to its sophisticated structure.

Also, according to the present invention, it is possible to effectively reduce power consumption which occurs due to a continuous operation of an electrical switch since an interrupt signal generated in response to detection of a user input from any one of the mechanical switches is used as an activating signal of an electrical switch.

Although a few embodiments of the present invention have been shown and described using limited number of drawings and specific elements, the present invention is not limited to the described embodiments.

Instead, it would be appreciated by those skilled in the art that changes may be made to these embodiments without departing from the invention, the scope of which is defined by the claims and their equivalents.

## Claims

1. A user input apparatus (300), comprising:
a plurality of input ports (310, 511, 521, 531) and a plurality of user input processing blocks (510, 520, 530) which are respectively connected to the corresponding input ports,
a first input port (310, 511) being connected to a mechanical switch (350, 512), for receiving a user input signal via the mechanical switch (350, 512);
a second input port (310, 521) being connected to an electrical switch (350, 522), for receiving a user input signal via the electrical switch (350, 522);
wherein the user input processing blocks (510, 520, 530) include:
a switch selection unit (340) storing an electrical input unit activating information in case the input port (310) is connected to the electrical switch, and storing a mechanical input unit activating information in case the input port (310) is connected to the mechanical switch (350);
an electrical input unit (320) for receiving an electrical input signal inputted via the electrical switch (350, 522), in case the electrical input unit activating information is stored in the switch selection unit (340);
a mechanical input unit (330) for receiving a mechanical input signal inputted via the mechanical switch (350), in case the mechanical input unit activating information is stored in the switch selection unit (340); and
an interrupt generation unit (360) for generating and outputting an interrupt signal when the mechanical input signal is received via at least one of the plurality of the mechanical input units (330),
for inputting the interrupt signal to a controller that controls the user input apparatus (300), such that, when the interrupt signal is received, the controller activates, among the plurality of input ports (310), the electrical input unit (320) of the second input port (310) being connected to the electrical switch (350, 522).

2. The apparatus (300) of claim 1, wherein the electrical switch is a touch sensing switch that senses changes in electrical characteristics occurring due to a user's touch and generates the user input signal.

3. The apparatus (300) of claim 1, wherein the electrical input unit (320) includes:
a control signal generation unit generating a control signal for driving the electrical switch; and
an input signal receiving unit receiving the electrical input signal from the electrical switch.

4. The apparatus (300) of claim 1, wherein the mechanical input unit (330) includes a pull-up resistance connected between a pull-up power terminal and the input port (310), and a voltage level of the mechanical input signal falls when the mechanical switch (350) is closed.

5. The apparatus (300) of claim 1, wherein the mechanical input unit (330) includes a pull-down resistance connected between ground and the input port (310), and a voltage level of the mechanical input signal rises when the mechanical switch (350) is closed.

6. The apparatus (300) of claim 1, wherein the interrupt generation unit performs a logical AND operation on output signals from the plurality of mechanical input units (330) to thereby output its result as the interrupt signal.

7. The apparatus (300) of claim 1, wherein the interrupt signal is inputted to a controller that controls peripheral devices of a digital device including the user input apparatus (300), and the controller activates at least one of the peripheral devices when the interrupt signal is received.

8. The apparatus (300) of claim 1, wherein the input port (310) as well as the electrical input unit (320) and the mechanical input unit (330) connected thereto are provided in plural number.

9. The apparatus (300) of claim 1, wherein the electrical input unit (320) and the mechanical input unit (330) are integrated into a single chip.

10. The apparatus (300) of claim 1, further comprising:
a light emitting unit controller transmitting a light emitting control signal to a light emitting unit being connected to the input port (310),
wherein the light emitting control signal is generated in a corresponding manner with a user's input via the electrical switch or the mechanical switch (350) being associated with the light emitting unit.

11. The apparatus (300) of claim 10, wherein the electrical input unit (320), the mechanical input unit (330) and the light emitting unit controller are integrated into a single chip.

12. The apparatus (300) of claim 10, wherein the light emitting control signal turns on the light emitting unit for a predetermined time when the user input signal is received from the electrical switch located adjacent to the light emitting unit.

13. The apparatus (300) of claim 1, further comprising:
a sound unit controller transmitting a sound unit control signal to a sound unit being connected to the input port (310),
wherein the sound control signal is generated in a corresponding manner with the user input signal via the electrical switch or the mechanical switch (350) being associated with the sound unit.

14. The apparatus (300) of claim 13, wherein the electrical input unit (320), the mechanical input unit (330) and the sound unit controller are integrated into a single chip.

15. The apparatus (300) of claim 1, wherein the switch selection unit (340) includes a register storing a flag value, the flag value being used to select either the electrical input unit (320) or the mechanical input unit (330).

16. The apparatus (300) of claim 1, wherein the user input apparatus (300) is mounted in a digital device, and further comprises a device controller generating a device control signal for controlling the digital device based on the electrical input signal or the mechanical input signal.

17. The apparatus (300) of claim 1, wherein
the user input apparatus (300), the electrical switch and the mechanical switch (350) are mounted in a first body of a portable terminal device, whereas a controller is mounted in a second body of the portable terminal, the controller being electrically connected to the user input apparatus (300) to drive or control the user input apparatus (300), and
the first and second body are fixed to, or slid or rotated with respect to each other, while being functionally combined to each other, and
the controller transmits a signal to the user input apparatus (300) via a predetermined cable in order to drive or control the user input apparatus (300).

## Patentansprüche

1. Benutzereingabevorrichtung (300), umfassend:
mehrere Eingabeanschlüsse (310, 511, 521, 531) und mehrere Benutzereingabeverarbeitungsblöcke (510, 520, 530), die jeweils mit den entsprechenden Eingabeanschlüssen verbunden sind,
einen ersten Eingabeanschluss (310, 511), verbunden mit einem mechanischen Schalter (350, 512), zum Empfangen eines Benutzereingabesignals über den elektrischen Schalter (350, 512);
einen zweiten Eingabeanschluss (310, 521), verbunden mit einem elektrischen Schalter (350, 522), zum Empfangen eines Benutzereingabesignals über den elektrischen Schalter (350, 522);
wobei die Benutzereingabeverarbeitungsblöcke (510, 520, 530) umfassen:
eine Schalterauswahleinheit (340) zum Speichern einer Information, die eine elektrische Eingabeeinheit aktiviert, falls der Eingabeanschluss (310) mit dem elektrischen Schalter verbunden ist, und zum Speichern einer Information, die eine mechanische Eingabeeinheit aktiviert, falls der Eingabeanschluss (310) mit dem mechanischen Schalter (350) verbunden ist;
eine elektrische Eingabeeinheit (320) zum Empfangen eines elektrischen Eingabesignals über den elektrischen Schalter (350, 522), falls die Information, die die elektrische Eingabeeinheit aktiviert, in der Schalterauswahleinheit (340) gespeichert ist;
eine mechanische Eingabeeinheit (330) zum Empfangen eines mechanischen Eingabesignals, eingegeben über den mechanischen Schalter (350), falls die Information, die die mechanische Eingabeeinheit aktiviert, in der Schalterauswahleinheit (340) gespeichert ist; und
eine Unterbrechungserzeugungseinheit (360) zum Erzeugen und Ausgeben eines Unterbrechungssignals, wenn das mechanische Eingabesignal über mindestens eine der mehreren mechanischen Eingabeeinheiten (330) empfangen wird,
zum Eingeben des Unterbrechungssignals zu einem Controller, der die Benutzereingabevorrichtung (300) so steuert, dass, wenn das Unterbrechungssignal empfangen wird, der Controller unter den mehreren Eingabeanschlüssen (310) die elektrische Eingabeeinheit (320) des zweiten Eingabeanschlusses (310), verbunden mit dem elektrischen Schalter (350, 522), aktiviert.

2. Vorrichtung (300) nach Anspruch 1, wobei der elektrische Schalter ein Berührungsfühlschalter ist, der Veränderungen in elektrischen Merkmalen infolge der Berührung durch einen Benutzer wahrnimmt und das Benutzereingabesignal erzeugt.

3. Vorrichtung (300) nach Anspruch 1, wobei die elektrische Eingabeeinheit (320) umfasst:
eine Steuersignalerzeugungseinheit, die ein Steuersignal zum Antreiben des elektrischen Schalters erzeugt; und
eine Eingabesignalempfangseinheit, die das elektrische Eingabesignal von dem elektrischen Schalter empfängt.

4. Vorrichtung (300) nach Anspruch 1, wobei die mechanische Eingabeeinheit (330) einen Pull-up-Widerstand umfasst, verbunden zwischen einer Pull-up-Leistungsklemme und dem Eingabeanschluss (310), und ein Spannungsniveau des mechanischen Eingabesignals fällt, wenn der mechanische Schalter (350) geschlossen wird.

5. Vorrichtung (300) nach Anspruch 1, wobei die mechanische Eingabeeinheit (330) einen Pull-down-Widerstand umfasst, verbunden zwischen Erde und dem Eingabeanschluss (310), und ein Spannungsniveau des mechanischen Eingabesignals steigt, wenn der mechanische Schalter (350) geschlossen wird.

6. Vorrichtung (300) nach Anspruch 1, wobei die Unterbrechungserzeugungseinheit einen logischen UND-Vorgang an Ausgabesignalen von den mehreren mechanischen Eingabeeinheiten (330) durchführt, um dadurch ihr Ergebnis als das Unterbrechungssignal auszugeben.

7. Vorrichtung (300) nach Anspruch 1, wobei das Unterbrechungssignal an einen Controller eingegeben wird, der Peripheriegeräte eines digitalen Geräts, einschließlich der Benutzereingabevorrichtung (300), steuert, und der Controller mindestens eines der Peripheriegeräte aktiviert, wenn das Eingabesignal empfangen wird.

8. Vorrichtung (300) nach Anspruch 1, wobei der Eingabeanschluss (310) sowie die elektrische Eingabeeinheit (320) und die daran angeschlossene mechanische Eingabeeinheit (330) in mehrfacher Anzahl bereitgestellt sind.

9. Vorrichtung (300) nach Anspruch 1, wobei die elektrische Eingabeeinheit (320) und die mechanische Eingabeeinheit (330) in einen einzigen Chip integriert sind.

10. Vorrichtung (300) nach Anspruch 1, ferner umfassend:
einen lichtemittierenden Einheitscontroller, der ein lichtemittierendes Steuersignal an eine an den Eingangsanschluss (310) angeschlossene lichtemittierende Einheit sendet,
wobei das lichtemittierende Steuersignal auf entsprechende Weise mit einer Benutzereingabe über den elektrischen Schalter oder den mechanischen Schalter (350), verbunden mit der lichtemittierenden Einheit, erzeugt wird.

11. Vorrichtung (300) nach Anspruch 10, wobei die elektrische Eingabeeinheit (320), die mechanische Eingabeeinheit (330) und der lichtemittierende Einheitscontroller in einen einzigen Chip integriert sind.

12. Vorrichtung (300) nach Anspruch 10, wobei das lichtemittierende Steuersignal die lichtemittierende Einheit während einer vorbestimmten Zeit einschaltet, wenn das Benutzereingabesignal von dem elektrischen Schalter, angeordnet neben der lichtemittierenden Einheit, empfangen wird.

13. Vorrichtung (300) nach Anspruch 1, ferner umfassend:
einen Klangeinheit-Controller, der ein Klangeinheit-Steuersignal an eine an den Eingabeanschluss (310) angeschlossene Klangeinheit sendet,
wobei das Klangsteuersignal auf entsprechende Weise mit dem Benutzereingabesignal über den elektrischen Schalter oder den mechanischen Schalter (350), verbunden mit der Klangeinheit, erzeugt wird.

14. Vorrichtung (300) nach Anspruch 13, wobei die elektrische Eingabeeinheit (320), die mechanische Eingabeeinheit (330) und der Klangeinheit-Controller in einen einzigen Chip integriert sind.

15. Vorrichtung (300) nach Anspruch 1, wobei die Schalterauswahleinheit (340) ein Register umfasst, das einen Flag-Wert speichert, der verwendet wird, um entweder die elektrische Eingabeeinheit (320) oder die mechanische Eingabeeinheit (330) auszuwählen.

16. Vorrichtung (300) nach Anspruch 1, wobei die Benutzereingabevorrichtung (300) in einem digitalen Gerät montiert ist und ferner einen Gerätecontroller umfasst, der ein Gerätsteuersignal zum Steuern des digitalen Geräts basierend auf dem elektrischen Eingabesignal oder dem mechanischen Eingabesignal erzeugt.

17. Vorrichtung (300) nach Anspruch 1, wobei
die Benutzereingabevorrichtung (300), der elektrische Schalter und der mechanische Schalter (350) in einem ersten Körper eines tragbaren Endgerätes montiert sind, während ein Controller in einem zweiten Körper des tragbaren Endgerätes montiert ist, wobei der Controller elektrisch mit der Benutzereingabevorrichtung (300) verbunden ist, um die Benutzereingabevorrichtung (300) anzutreiben oder zu steuern, und
der erste und zweite Körper zueinander fixiert oder zueinander gleitend oder drehend sind, während sie funktionell miteinander kombiniert sind, und
der Controller über ein vorbestimmtes Kabel ein Signal an die Benutzereingabevorrichtung (300) sendet, um die Benutzereingabevorrichtung (300) anzutreiben oder zu steuern.

## Revendications

1. Appareil d'entrée d'utilisateur (300), comprenant :
une pluralité de ports d'entrée (310, 511, 521, 531) et une pluralité de blocs de traitement d'entrée d'utilisateur (510, 520, 530) qui sont respectivement connectés aux ports d'entrée correspondants,
un premier port d'entrée (310, 511) étant connecté à un commutateur mécanique (350, 512) pour recevoir un signal d'entrée d'utilisateur via le commutateur mécanique (350, 512) ;
un deuxième port d'entrée (310, 521) étant connecté à un commutateur électrique (350, 522) pour recevoir un signal d'entrée d'utilisateur via le commutateur électrique (350, 522) ;
dans lequel les blocs de traitement d'entrée d'utilisateur (510, 520, 530) comprennent :
une unité de sélection de commutateur (340) stockant une information d'activation d'unité d'entrée électrique dans le cas où le port d'entrée (310) est connecté au commutateur électrique, et stockant une information d'activation d'unité d'entrée mécanique dans le cas où le port d'entrée (310) est connecté au commutateur mécanique (350) ;
une unité d'entrée électrique (320) pour recevoir un signal d'entrée électrique introduit par l'intermédiaire du commutateur électrique (350, 522), dans le cas où l'information d'activation d'unité d'entrée électrique est stockée dans l'unité de sélection de commutateur (340) ;
une unité d'entrée mécanique (330) pour recevoir un signal d'entrée mécanique introduit par l'intermédiaire du commutateur mécanique (350), dans le cas où l'information d'activation d'unité d'entrée mécanique est stockée dans l'unité de sélection de commutateur (340) ; et
une unité de génération d'interruption (360) pour générer et délivrer un signal d'interruption quand le signal d'entrée mécanique est reçu via au moins l'une de la pluralité d'unités d'entrée mécanique (330),
pour transmettre le signal d'interruption à un contrôleur qui commande l'appareil d'entrée d'utilisateur (300), de telle manière que, lorsque le signal d'interruption est reçu, le contrôleur active, parmi la pluralité de ports d'entrée (310), l'unité d'entrée électrique (320) du deuxième port d'entrée (310) qui est connectée au commutateur électrique (350, 522).

2. Appareil (300) selon la revendication 1, dans lequel le commutateur électrique est un commutateur tactile qui détecte les variations de caractéristiques électriques dues au toucher d'un utilisateur et qui génère le signal d'entrée d'utilisateur.

3. Appareil (300) selon la revendication 1, dans lequel l'unité d'entrée électrique (320) comprend :
une unité de génération de signal de commande qui génère un signal de commande pour entraîner le commutateur électrique ; et
une unité de réception de signal d'entrée qui reçoit le signal d'entrée électrique du commutateur électrique.

4. Appareil (300) selon la revendication 1, dans lequel l'unité d'entrée mécanique (330) comprend une résistance de rappel vers le niveau haut connectée entre une borne d'alimentation de rappel vers le niveau haut et le port d'entrée (310), et un niveau de tension du signal d'entrée mécanique chute quand le commutateur mécanique (350) est fermé.

5. Appareil (300) selon la revendication 1, dans lequel l'unité d'entrée mécanique (330) comprend une résistance de rappel vers le niveau bas connectée entre la masse et le port d'entrée (310), et un niveau de tension du signal d'entrée mécanique augmente quand le commutateur mécanique (350) est fermé.

6. Appareil (300) selon la revendication 1, dans lequel l'unité de génération d'interruption réalise une opération logique ET sur les signaux de sortie de la pluralité d'unités d'entrée mécanique (330) pour délivrer ainsi son résultat en tant que signal d'interruption.

7. Appareil (300) selon la revendication 1, dans lequel le signal d'interruption est transmis à un contrôleur qui commande les dispositifs périphériques d'un dispositif numérique comprenant l'appareil d'entrée d'utilisateur (300), et le contrôleur active au moins l'un des dispositifs périphériques quand le signal d'interruption est reçu.

8. Appareil (300) selon la revendication 1, dans lequel le port d'entrée (310) ainsi que l'unité d'entrée électrique (320) et l'unité d'entrée mécanique (330) qui y sont connectées sont fournis en un nombre supérieur à un.

9. Appareil (300) selon la revendication 1, dans lequel l'unité d'entrée électrique (320) et l'unité d'entrée mécanique (330) sont intégrées en une seule puce.

10. Appareil (300) selon la revendication 1, comprenant en outre :
un contrôleur d'unité d'émission de lumière qui transmet un signal de commande d'émission de lumière à une unité d'émission de lumière qui est connectée au port d'entrée (310),
dans lequel le signal de commande d'émission de lumière est généré de manière correspondante avec une entrée d'un utilisateur par l'intermédiaire du commutateur électrique ou du commutateur mécanique (350) qui est associé à l'unité d'émission de lumière.

11. Appareil (300) selon la revendication 10, dans lequel l'unité d'entrée électrique (320), l'unité d'entrée mécanique (330) et le contrôleur d'unité d'émission de lumière sont intégrés en une seule puce.

12. Appareil (300) selon la revendication 10, dans lequel le signal de commande d'émission de lumière allume l'unité d'émission de lumière pendant une durée prédéterminée quand le signal d'entrée d'utilisateur est reçu en provenance du commutateur électrique qui est adjacent à l'unité d'émission de lumière.

13. Appareil (300) selon la revendication 1, comprenant en outre :
un contrôleur d'unité de son qui transmet un signal de commande d'unité de son à une unité de son qui est connectée au port d'entrée (310),
dans lequel le signal de commande de son est généré d'une manière correspondante avec le signal d'entrée d'utilisateur par l'intermédiaire du commutateur électrique ou du commutateur mécanique (350) qui est associé à l'unité de son.

14. Appareil (300) selon la revendication 13, dans lequel l'unité d'entrée électrique (320), l'unité d'entrée mécanique (330) et le contrôleur d'unité de son sont intégrés en une seule puce.

15. Appareil (300) selon la revendication 1, dans lequel l'unité de sélection de commutateur (340) comprend un registre qui stocke une valeur de drapeau, la valeur de drapeau étant utilisée pour sélectionner soit l'unité d'entrée électrique (320), soit l'unité d'entrée mécanique (330).

16. Appareil (300) selon la revendication 1, dans lequel l'appareil d'entrée d'utilisateur (300) est monté dans un dispositif numérique, et comprend en outre un contrôleur de dispositif qui génère un signal de commande de dispositif pour commander le dispositif numérique en se basant sur le signal d'entrée électrique ou le signal d'entrée mécanique.

17. Appareil (300) selon la revendication 1, dans lequel :
l'appareil d'entrée d'utilisateur (300), le commutateur électrique et le commutateur mécanique (350) sont montés dans un premier châssis d'un dispositif de terminal portable, tandis qu'un contrôleur est monté dans un deuxième châssis du terminal portable, le contrôleur étant connecté électriquement à l'appareil d'entrée d'utilisateur (300) pour entraîner ou commander l'appareil d'entrée d'utilisateur (300), et
les premier et deuxième châssis sont fixés, ou glissants ou rotatifs l'un par rapport à l'autre, tout en étant combinés fonctionnellement l'un à l'autre, et
le contrôleur transmet un signal à l'appareil d'entrée d'utilisateur (300) via un câble prédéterminé afin d'entraîner ou de commander l'appareil d'entrée d'utilisateur (300).
